# DEMANDE DE BREVET EUROPEEN

(11) **EP 1 479 789 A1**
(43) Date de publication de la demande: **24.11.2004**
(21) Numéro de dépôt: 03447123.5
(22) Date de dépôt: 23.05.2003
(51) Int. Cl.: C23C 14/56, F16J 15/16, B29C 37/00

(54) **Sas d'étanchéité pour ligne de dépôt sous vide sur produit plat**

(71) Demandeur: RECHERCHE ET DEVELOPPEMENT DU GROUPE COCKERILL SAMBRE, 4000 Liège (BE)
(72) Inventeur: Coolen, Stéphane, 4550 Nandrin (BE); Silberberg, Eric, 5340 Gesves (BE); Marneffe, Didier, 4480 Engis (BE); d'Hondt, Bernard, 1120 Bruxelles (BE); de Felice, Claudio, 4450 Juprelle (BE)
(74) Mandataire: Van Malderen, Michel

(57) **Abrégé**

La présente invention se rapporte à un sas d'étanchéité (5) pour une chambre de dépôt sous vide sur une bande, de préférence métallique, en défilement continu (1), caractérisé en ce que :
- les rouleaux métalliques (10,10' ; 11,11', ...) sont montés sur des paliers (30,30',...) solidaires des couvercles (6,7) et sont amovibles tout comme ces derniers ;
- les rouleaux d'une même paire ont leurs axes disposés dans un même plan vertical et sont de diamètres différents, la position du rouleau de plus faible diamètre (10',11',...) étant alternée haute/basse, lorsqu'on passe d'une paire de rouleaux donnée à la paire adjacente ;
- les berceaux (40,40' ; 41,41' ; ...) de maintien de deux rouleaux d'une même paire présentent un prolongement latéral (9,9') vers le centre dont l'espacement avec la table desdits rouleaux définit une seconde fuite.

## Description

### Objet de l'invention

La présente invention se rapporte à un sas d'étanchéité amélioré en entrée et/ou sortie d'une ligne de dépôt d'une couche mince sous vide sur produit plat en mouvement, de préférence une bande de métal (acier carbone, inox, etc.).

### Etat de la technique

A l'intérieur d'une chambre de dépôt sous vide (pression de l'ordre de 10⁻⁵ mbar) peuvent être mis en oeuvre de nombreux procédés : nettoyage, dépôt(s), etc.

En sidérurgie et métallurgie, les lignes pour dépôts métalliques (métal pur, alliages, oxydes) ou organiques sous vide en continu présentent un intérêt grandissant pour plusieurs raisons.

D'abord, elles offrent une grande facilité de développement de nouveaux produits. Aujourd'hui le revêtement de bandes d'acier se limite industriellement au procédé de revêtement au trempé ou au procédé d'électrolyse, qui sont des procédés classiques. Le nombre de produits ainsi obtenus est très limité. L'industrialisation de lignes de dépôt sous vide, dont le principe est aujourd'hui au point en ligne pilote, permettrait de concevoir des dizaines de nouveaux produits.

Ensuite, du point de vue de la protection de l'environnement, si le procédé de revêtement au trempé est relativement propre, hormis la production de mattes, le procédé d'électrolyse demande des traitements chimiques annexes tels que le filtrage, la régénération, le traitement des boues, etc. Dans tous les cas, la préparation de surface produit des effluents à traiter sous forme de bains et boues. A l'opposé, le dépôt sous vide mettant en oeuvre un plasma ou non est un procédé à sec. Il faut uniquement récupérer les déchets secs provenant du nettoyage des surfaces et les pertes de dépôt.

On connaît des sas d'étanchéité destinés à isoler la chambre de dépôt sous vide des autres éléments de la ligne tels que dérouleuse, enrouleuse, etc. Le sas est un élément dont la maîtrise est très importante pour la phase d'industrialisation. L'état de la technique décrit des réalisations de sas (US-A-3 158 507, US-A-3 367 667, US-A-3 467 399, US-A-3 868 106, US-A-4 501 428, US-A-5 000 114, EP-A-0 535 568, US-A-5 842 855, US-A-5 865 932). La plupart de ces réalisations n'ont pas donné lieu à une industrialisation effective.

La plupart du temps, afin de se prémunir de fuites existant au niveau du point faible que constitue le sas d'entrée ou sortie, on évite l'utilisation de sas. Dans le verre, on effectue des dépôts en batch de plateaux de dimensions standards. Dans le plastique, on adopte la solution du bobinage à même la chambre sous vide.

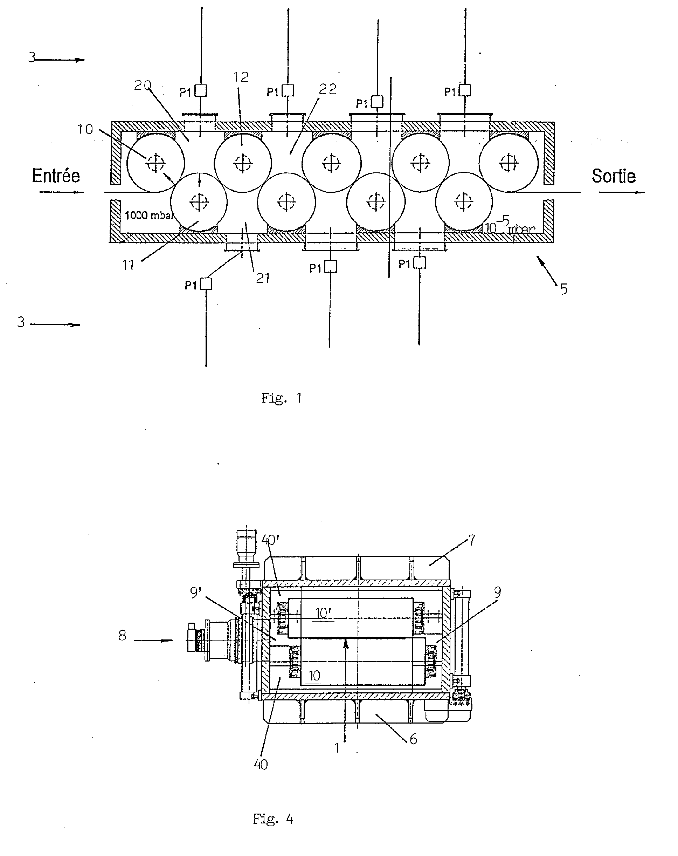

Un exemple de sas d'entrée/sortie 5 pour chambre de dépôt sous vide est illustré à la figure 1. Dans ce sas, 9 rouleaux 10,11,12,..., sont disposés en quinconce et défissent 7 sous-chambres 20,21,22,... Chacune des sous-chambres est reliée à un système de pompage 3. L'ensemble des systèmes de pompage 3 permet d'obtenir un vide progressif de chambre en chambre 20,21,22,..., dont la valeur dans la dernière sous-chambre peut aller jusqu'à 10⁻⁵ mbar. La disposition en quinconce est favorable à la diminution du nombre de rouleaux et à la compacité du sas. De plus, la bande forme un arc lors du passage dans les rouleaux, ce qui assure de fait une étanchéité sur la largeur de bande, qui est nettement améliorée par rapport à un entrefer de rouleaux simple. Ainsi, un écartement plus grand entre deux rouleaux devient tolérable.

Chaque rouleau est de plus disposé dans un berceau solidaire de la paroi horizontale, inférieure ou supérieure, selon le cas, de la chambre faisant face au rouleau. A cet endroit, la fuite est réduite à l'écartement ou au jeu entre le rouleau et le berceau. Il reste également des fuites entre les flancs des rouleaux cylindriques et les parois latérales de la chambre.

Enfin, afin d'assurer le maintien de l'étanchéité dans chaque sous-chambre, il est nécessaire que la pression de contact entre la bande et les rouleaux servant à l'étanchéité d'une sous-chambre soit au moins égale à la différence des pressions entre ladite sous-chambre et son environnement. Dans le cas contraire, il y a un risque de décollement de la bande du rouleau. Pour éviter ce problème, il convient d'appliquer à la bande une traction suffisante que pour reprendre la différence de pression existant entre deux sous-chambres consécutives.

Pour l'industrialisation dans le cas d'un défilement continu, un certain nombre de problèmes de l'état de la technique sont à résoudre. Tout d'abord se pose le problème de la maintenabilité de l'outil. On doit pouvoir enfiler aisément la bande dans le sas. De plus le caisson constituant la chambre à vide a une hauteur limitée et donc une accessibilité faible. Il convient, dans l'état de l'art actuel, par exemple pour contrôler l'état de surface des rouleaux, de démonter complètement la chambre. Un autre problème existant est lié aux pertes de vide liées aux fuites présentes dans le sas, ce qui affecte les performances de pompage. Il en résulte une consommation électrique importante et un investissement lourd en équipements de pompage.

La faiblesse ou l'absence des échanges thermiques, par définition, dans la partie sous vide du caisson n'implique aucune dilatation des rouleaux du côté vide. En effet, le seul contact de rugosité est insuffisant pour assurer la conduction thermique entre la bande chaude et les rouleaux situés côté vide. Par contre, une dilatation des rouleaux se produit côté air par échange thermique, qui se propage éventuellement à l'enveloppe externe du caisson. Cette dilatation des rouleaux sur leur longueur augmente le risque de grippage par contact de ceux-ci avec les parois latérales de la chambre. La déformation n'est en effet pas suivie par la partie externe du caisson située côté air dans la mesure où celle-ci est solidaire de la partie située côté vide, qui ne se dilate pas.

### Buts de l'invention

La présente invention vise à fournir un sas d'étanchéité en entrée/sortie, pour une ligne de dépôt sous vide sur produit plat, qui permette de s'affranchir des inconvénients de l'état de la technique.

L'invention vise en particulier à fournir un sas d'étanchéité qui puisse être utilisé sur une ligne continue de dépôt sous vide sur produit plat métallique tel que bande d'acier carbone ou inoxydable.

L'invention a pour but complémentaire de fournir un sas de maintenabilité aisée (enfilement de la bande, accès aux rouleaux, etc.).

L'invention a encore pour but de fournir un sas permettant d'obtenir de meilleures performances de pompage tout en réduisant la consommation électrique y afférente et en minimisant les équipements nécessaires.

L'invention a encore pour but de prévenir le risque de grippage des rouleaux associé à la dilatation des pièces métalliques partiellement sous vide.

Enfin, l'invention a pour but de prévenir l'usure préférentielle des rouleaux munis d'un revêtement additionnel en caoutchouc.

### Principaux éléments caractéristiques de l'invention

Un premier objet de la présente invention se rapporte à un sas d'étanchéité pour une chambre de dépôt sous vide sur une bande de préférence métallique en défilement continu, présentant un couvercle inférieur et un couvercle supérieur amovibles, comprenant une pluralité de paires de rouleaux métalliques entre lesquels passe la bande et maintenus dans un berceau fixé au couvercle lui faisant face avec un espacement définissant une première fuite, deux paires de rouleaux successives quelconques définissant une sous-chambre maintenue à une pression déterminée, inférieure à la pression atmosphérique, par un groupe de pompage connecté à ladite chambre, caractérisé en ce que :
- les rouleaux sont montés sur des paliers solidaires desdits couvercles et sont également amovibles ;
- les rouleaux d'une même paire ont leurs axes disposés dans un même plan vertical et sont de diamètres différents, la position du rouleau de plus faible diamètre étant alternée haute/basse, lorsqu'on passe d'une paire de rouleaux donnée à la paire adjacente ;
- les berceaux de maintien de deux rouleaux d'une même paire présentent un prolongement latéral vers le centre dont l'espacement avec la surface latérale desdits rouleaux définit une seconde fuite.

Selon une forme d'exécution préférée de l'invention, les rouleaux de plus petit diamètre sont recouverts d'une certaine épaisseur de caoutchouc ou d'élastomère.

Avantageusement, les rouleaux de plus grand diamètre sont des rouleaux dont la surface de contact avec la bande est métallique et définit la ligne de passe de la bande.

Selon une forme d'exécution encore préférée, deux rouleaux d'une même paire sont désalignés dans la direction transversale par rapport au mouvement de la bande, de manière telle que, de chaque côté latéral du sas, un des rouleaux présente un débordement par rapport à l'autre rouleau.

De manière particulièrement avantageuse, l'étanchéité de chaque sous-chambre du sas est assurée entre la bande et la table des deux rouleaux par une précontrainte du rouleau recouvert de caoutchouc sur le rouleau à surface métallique, permettant à la fois le passage de la bande et l'écrasement du caoutchouc ou de l'élastomère autour de la bande

Toujours avantageusement, l'angle de changement de direction de la bande est déterminé par le rapport des diamètres des rouleaux d'un même paire et est inférieur à 10°.

Un avantage essentiel de l'invention est de permettre que la pression la plus faible régnant dans une sous-chambre soit inférieure à 10⁻⁴ mbar, de préférence 10⁻⁵ mbar.

De préférence, l'espacement ou le jeu caractérisant la première fuite est fonction de la largeur maximale de la bande, tandis que celui caractérisant la seconde fuite est essentiellement constant et inférieur à 0,3 mm, de préférence 0,2 mm.

Un deuxième objet de la présente invention concerne une installation de type ligne de dépôt sous vide d'une couche mince métallique ou organique sur un produit métallurgique ou sidérurgique plat en mouvement à une vitesse d'au moins 10 m/min, de préférence une bande d'acier carbone ou inoxydable, comprenant un sas d'étanchéité en entrée et/ou en sortie tel que décrit ci-dessus.

### Brève description des figures

La figure 1, déjà mentionnée ci-dessus, représente une vue en coupe d'un sas d'étanchéité pour une chambre de dépôt sous vide, selon l'état de la technique.

La figure 2 représente une vue en coupe verticale et longitudinale d'un sas d'étanchéité pour une chambre de dépôt sous vide, selon une forme d'exécution préférée de l'invention. La figure 2 montre également les deux couvercles escamotables.

La figure 3 représente une vue du dessus du sas d'étanchéité pour chambre de dépôt sous vide de la figure 2.

La figure 4 représente une vue en coupe verticale et transversale du sas de la figure 2.

### Description d'une forme d'exécution préférée de l'invention

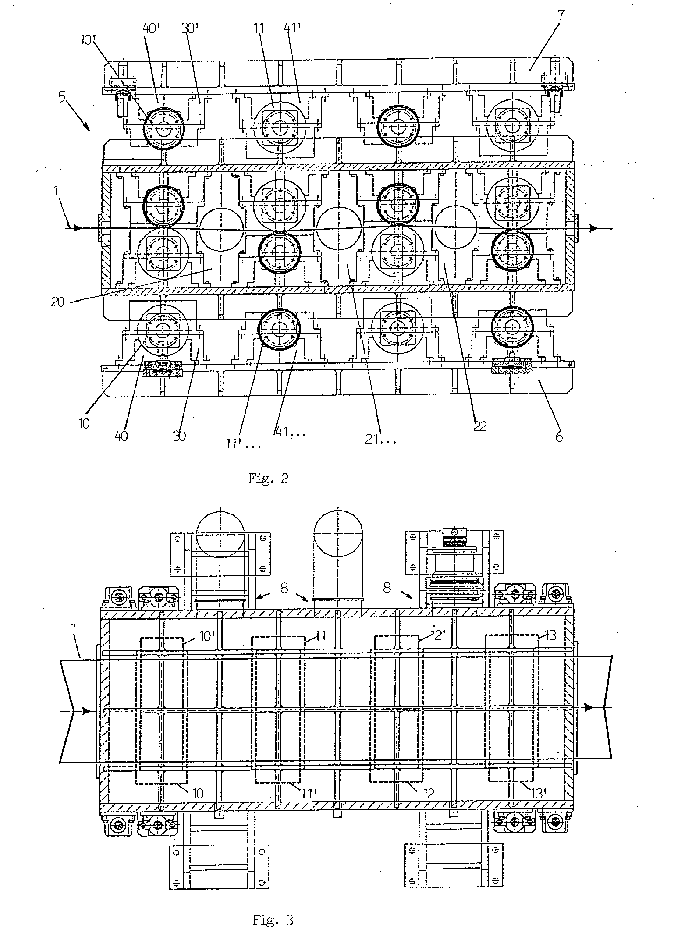

Les figures 2 et 3 représentent un exemple de sas d'entée/sortie pour chambre de dépôt sous vide selon la présente invention. La bande métallique 1 pénètre dans le sas par la gauche et en ressort par la droite. Dans le cas d'espèce, la chambre 5 comporte 4 paires de rouleaux en vis-à-vis 10, 10 ', 11, 11' , ... entre lesquels est enfilée la bande. Lesdites paires de rouleaux délimitent des sous-chambres 20,21,22,... dans chacune desquelles règnent des pressions différentes, et allant successivement en décroissant pour un sas d'entrée par exemple. Dans le cas d'un sas de sortie, la situation inverse prévaut.

Selon l'invention, afin d'assurer la maintenabilité de la chambre et l'accès aux rouleaux, on prévoit que les paliers des rouleaux 30,30', ... sont escamotables et solidaires du couvercle inférieur 6 ou supérieur 7 de la chambre, selon la position, respectivement basse ou haute, du rouleau considéré. On prévoit également que l'on puisse écarter suffisamment dans un plan vertical les deux couvercles 6 et 7, au moyen de vérins (non représentés). Ainsi, lors d'une opération de maintenance, on peut aisément accéder aux rouleaux ou aux paliers. Un autre avantage réside dans la facilité d'enfilement de la bande.

Un certain nombre d'éléments ont été conçus pour améliorer l'étanchéité de la chambre au niveau de chaque paire de rouleaux.

D'abord, le rouleau de plus petit diamètre 10', 11', 12', ... est muni, au moins sur toute sa surface de contact, d'un recouvrement en caoutchouc ou élastomère. Ainsi, pour chaque paire de rouleaux, le rouleau métallique détermine la ligne de passe de la bande, tandis que la position du rouleau recouvert de caoutchouc est ajustée initialement pour que celui-ci presse suffisamment sur le rouleau métallique correspondant, en se déformant au niveau du caoutchouc, pour épouser le profil de la bande (voir figure 4). Ainsi, grâce à l'écrasement de la bande entre le caoutchouc et le rouleau métallique nu, l'étanchéité est assurée en surface de la bande, sur toute sa largeur, et au niveau des côtés latéraux de la bande.

Avantageusement, on peut prévoir que les rouleaux 10, 10', ... présentent des diamètres différents alternativement de chaque côté de la bande 1 (par exemple 300 et 250 mm respectivement). Ainsi, la bande adopte un chemin non rectiligne (brisure de la ligne de passe). L'usure se concentrant sur le plus grand angle de contact, on minimise celle du rouleau recouvert de caoutchouc. Cependant, par le fait que les rouleaux sont alignés par paires et que la bande est pressée entre eux, on bénéficie de l'avantage qu'il n'y a plus lieu de se préoccuper d'une contrainte de ΔP entre l'atmosphère et la première sous-chambre de vide, ce qui permet de pomper plus dans cette dernière. De plus, la traction exercée sur la bande n'est pas critique pour le maintien de l'étanchéité des différentes sous-chambres de vide à hauteur de la bande.

De plus, les rouleaux sont maintenus du côté du couvercle 6,7 qui leur fait face dans un berceau 40,40',41,41',... Cette disposition permet de minimiser la fuite, dépendant entre autres du jeu entre le berceau et le rouleau, comme cela sera expliqué ci-après.

En effet, selon l'invention, les problèmes de fuite et de dilatation thermique au niveau des parois latérales sont résolus :
- d'une part en prolongeant les berceaux supérieur (40', ...) et inférieur (40,...) des rouleaux latéralement, par un retour vers le centre (9,9'), tel que représenté à la figure 4, et,
- d'autre part, en décalant les rouleaux de chaque paire (10, 10', ...) l'un par rapport à l'autre sur la largeur de la chambre.

Ainsi, selon la face latérale, chacun des deux rouleaux présente un débordement par rapport à l'autre rouleau et inversement. Cette disposition permet le positionnement du berceau modifié (40,40' , ...) tel que décrit ci-dessus. On notera que par construction le berceau modifié ne se trouve pas transversalement du même côté pour les deux rouleaux. Sur chaque rouleau, le palier correspondant au berceau modifié a une double fonction :
- reprise de la dilatation thermique du cylindre considéré ;
- maintien d'un jeu latéral constant, c'est-à-dire indépendant de ladite dilatation, ou, énoncé de manière équivalente, indépendant de la longueur effective des rouleaux. La fuite latérale, c'est-à-dire sise le long de la surface latérale du rouleau est donc indépendante de la dilatation thermique. L'étanchéité ne se fait plus sur le flanc mais sur la table du rouleau.

Pour des régimes d'écoulements laminaire et moléculaire, il convient d'allonger le plus possible le chemin du gaz au niveau de la chambre. En régime moléculaire, les pompes doivent être le plus près possible de la source et les sections 8 les plus importantes possibles (figure 3 et 4).

Les caractéristiques d'amélioration de sas pour chambre de dépôt sous vide selon l'invention présentent donc les avantages suivants :
- la maintenabilité est rendue plus aisée et moins coûteuse grâce à l'utilisation de bancs de rouleaux escamotables ;
- les performances de pompage sont améliorées et partant, la consommation d'énergie électrique et les investissements en équipement réduits, suite à l'amélioration de l'étanchéité (désalignement des rouleaux d'une même paire, déformation des rouleaux recouverts de caoutchouc) ;
- les problèmes de dilatation différentielle des pièces métalliques dus à la mise sous vide sont résolus par l'adoption de berceaux modifiés sous forme de socles reprenant le palier et prolongés sous forme d'une bague recouvrant partiellement la table ainsi que par le désalignement des rouleaux ;
- l'adoption de diamètres différents pour les rouleaux permet de favoriser l'usure du rouleau métallique et de minimiser celle du polymère.

## Revendications

1. Sas d'étanchéité (5) pour une chambre de dépôt sous vide sur une bande, de préférence métallique, en défilement continu (1), présentant un couvercle inférieur (6) et un couvercle supérieur (7) amovibles, comprenant une pluralité de paires de rouleaux métalliques (10,10' ; 11,11', ...) entre lesquels passe la bande (1) et maintenus dans un berceau (40,40' ; 41,41' ; ou) fixé au couvercle (6,7) lui faisant face avec un espacement définissant une première fuite, deux paires de rouleaux successives quelconques définissant une sous-chambre (20,21,22,...) maintenue à une pression déterminée, inférieure à la pression atmosphérique, par un groupe de pompage (3) connecté à ladite chambre, **caractérisé en ce que** :
- les rouleaux sont montés sur des paliers (30,30',...) solidaires desdits couvercles (6,7) et sont également amovibles ;
- les rouleaux d'une même paire ont leurs axes disposés dans un même plan vertical et sont de diamètres différents, la position du rouleau de plus faible diamètre (10',11',...) étant alternée haute/basse, lorsqu'on passe d'une paire de rouleaux donnée à la paire adjacente ;
- les berceaux (40, 40' ; 41, 41'; ...) de maintien de deux rouleaux d'une même paire présentent un prolongement latéral (9,9') vers le centre dont l'espacement avec la surface latérale desdits rouleaux définit une seconde fuite.

2. Sas d'étanchéité selon la revendication 1, **caractérisé en ce que** les rouleaux de plus petit diamètre (10',11', ...) sont recouverts d'une certaine épaisseur de caoutchouc ou d'élastomère.

3. Sas d'étanchéité selon la revendication 2, **caractérisé en ce que** les rouleaux de plus grand diamètre (10,11, ...) sont des rouleaux dont la surface de contact avec la bande (1) est métallique et définit la ligne de passe de la bande.

4. Sas d'étanchéité selon l'une quelconque des revendications 2 et 3, **caractérisé en ce que** deux rouleaux d'une même paire sont désalignés dans la direction transversale par rapport au mouvement de la bande, de manière telle que, de chaque côté latéral du sas, un des rouleaux présente un débordement par rapport à l'autre rouleau.

5. Sas d'étanchéité selon la revendication 4, **caractérisé en ce que** l'étanchéité de chaque sous-chambre du sas est assurée entre la bande et la table des deux rouleaux par une précontrainte du rouleau recouvert de caoutchouc sur le rouleau à surface métallique, permettant à la fois le passage de la bande et l'écrasement du caoutchouc ou de l'élastomère autour de la bande

6. Sas d'étanchéité selon l'une quelconque des revendications précédentes, **caractérisé en ce que** l'angle de changement de direction de la bande est déterminé par le rapport des diamètres des rouleaux d'une même paire et est inférieur à 10°.

7. Sas d'étanchéité selon l'une quelconque des revendications précédentes, **caractérisé en ce que** la pression la plus faible régnant dans une sous-chambre (20,21,22, ...) est inférieure à 10⁻⁴ mbar, de préférence 10⁻⁵ mbar.

8. Sas d'étanchéité selon l'une quelconque des revendications précédentes, **caractérisé en ce que** l'espacement caractérisant la première fuite est fonction de la largeur maximale de la bande.

9. Sas d'étanchéité selon l'une quelconque des revendications précédentes, **caractérisé en ce que** l'espacement caractérisant la seconde fuite est essentiellement constant et inférieur à 0,3 mm, de préférence 0,2 mm.

10. Installation de type ligne de dépôt sous vide d'une couche mince métallique ou organique sur un produit métallurgique ou sidérurgique plat en mouvement à une vitesse d'au moins 10 m/min, de préférence une bande d'acier carbone ou inoxydable, comprenant un sas d'étanchéité (5) en entrée et/ou en sortie selon l'une quelconque des revendications précédentes.
